# NEUE EUROPÄISCHE PATENTSCHRIFT

(11) **EP 3 772 876 B2**
(45) Veröffentlichungstag und Bekanntmachung des Hinweises auf die Entscheidung über den Einspruch: **17.06.2026**
(45) Hinweis auf die Patenterteilung: 08.02.2023
(21) Anmeldenummer: 20188590.2
(22) Anmeldetag: 30.07.2020
(51) Int. Cl.: H05K 7/20, H02B 1/56

(54) **VERTEILERSCHRANK**
DISTRIBUTION CABINET
ARMOIRE DE DISTRIBUTION

(30) Priorität: 09.08.2019 DE 202019003326 U
(43) Veröffentlichungstag der Anmeldung: 10.02.2021
(73) Patentinhaber: Hauff-Technik GRIDCOM GmbH, 73494 Rosenberg (DE)
(72) Erfinder: BRÜGGEMANN; Christian, 32791 Lage (DE)
(74) Vertreter: Szynka Smorodin Patentanwälte Partnerschaft mbB

(56) Entgegenhaltungen:
- EP-A1- 1 367 877
- EP-A2- 1 026 932
- WO-A1-96/34519
- CN-U- 208 257 201
- DE-A1- 1 806 029
- DE-A1- 102008 053 958
- DE-A1- 3 326 977
- DE-A1- 4 113 170
- DE-U1- 29 823 425
- DE-U1- 8 810 228
- US-A- 5 090 476
- US-A- 5 306 121
- US-B1- 6 260 373
- US-B2- 10 375 860
- US-B2- 7 814 760
- PFENDER C: "EINE KUEHLE SACHE KLIMATISIEREN ELEKTRONISCHER SYSTEME", ELEKTROTECHNIK FUER DIE AUTOMATISIERUNG, VOGEL BUSINESS MEDIA GMBH & CO.KG, vol. 72, no. 7/08, 30 August 1990 (1990-08-30), pages 42, 47 - 49, XP000159472, ISSN: 1431-9578

## Beschreibung

Die vorliegende Erfindung betrifft einen Verteilerschrank, der im Außenbereich aufgestellt wird.

Der in Rede stehende Verteilerschrank kann insbesondere als aktiver Kabelverzweiger in einem Telekommunikationsnetz eingesetzt werden. In diesem kann er funktional zwischen einem Hauptverteiler und den Verbrauchern oder selbst als Hauptverteiler angeordnet sein. Aus dem Orts- bzw. Stadtbild sind solche Verteilerkästen aufgrund ihrer typischen Positionierung am Straßenrand bekannt. An jeden Verteilerschrank sind mehrere umliegende Häuser bzw. Gebäude angebunden, die Verzweigung von Haupt- und Verzweigungskabel erfolgt im Schrankinnenraum. Dieser wird von einem Schrankkorpus begrenzt und ist über eine oder bei größeren Schränken mehrere Türen zugänglich.

Zum Stand der Technik wird zunächst verweisen auf die dem Oberbegriff des Anspruchs 1 zugrunde liegende EP 1 367 877 A1 mit einem Schaltschrank, auf dessen Oberseite eine Kompressionskältemaschine zur Kühlung des Innenraums vorgesehen ist, wobei die erzeugte Kaltluft von den Verdampfern dieser Kältemaschine durch Schlitze in den Innenraum geführt wird und die Kältemaschine in zwei Ebenen aufgebaut ist.

Ferner beschreibt die EP 1 026 932 A2 ein modulares System mit einem Schaltschrank und an dessen Außenfläche montierbaren Kühleinrichtungen unterschiedlicher Bauart, die gegeneinander austauschbar sein sollen, wobei eine dieser Bauarten eine aktive Kühleinrichtung ist, andere passive Kühleinrichtungen sind.

Die DE 88 10 228 U1 bezieht sich auf einen Schaltschrank mit ebenfalls oben angeordneter Kompressionskältemaschine, die aber wahlweise auch an einer Seite des Schaltschranks vorgesehen sein kann.

Auch die DE 33 26 977 A1 zeigt eine Kompressionskältemaschine für einen Schaltschrank, und zwar zur Anordnung oben.

Ergänzend wird noch verwiesen auf die DE 298 23 425 U1.

Der vorliegenden Erfindung liegt das technische Problem zugrunde, einen vorteilhaften Verteilerschrank anzugeben.

Dies wird erfindungsgemäß mit dem Verteilerschrank gemäß Anspruch 1 gelöst. Auf dessen Schrankkorpus ist ein Aufsatz mit einer Kältemaschine angeordnet, die über einen Wärmetauscher an den Schrankinnenraum gekoppelt ist. Die Kältemaschine ermöglicht eine aktive Kühlung, also eine Kühlung auf unterhalb der Umgebungstemperatur. Aufgrund der Kopplung über den Wärmetauscher ("erster Wärmetauscher") wird der Schrankinnenraum in einem geschlossenen Kreislauf gekühlt, wird also zur Kühlung keine Außenluft in den Schrankinnenraum eingeblasen. Dies kann bspw. den Wartungsaufwand verringern, der sich ansonsten aus dem Einsatz von Filtern etc. ergeben könnte.

Die Integration der Kältemaschine in den Aufsatz kann z. B. dahingehend von Vorteil sein, dass sich ein entsprechender Verteilerschrank dann nicht nur im Zuge einer Neuherstellung, sondern auch bei einer Nachrüstung im Bestand realisieren lässt. Der Aufsatz lässt sich auch nachträglich auf einen bereits installierten Verteilerschrank setzen, in den meisten Einbausituationen ist nämlich der zusätzliche Raumbedarf oberhalb des Verteilerschranks unkritisch, wohingegen der Schranckorpus mit seiner Rückwand bzw. den Seitenwänden vielfach an Wände bzw. Zäune etc. grenzt. Es gibt in der Praxis jedenfalls eine Divergenz, von welcher Seite her ein installierter Verteilerschrank noch zugänglich ist, sodass eine einheitliche Nachrüstung "von der Seite" kaum möglich wäre. Die Verteilerschränke sind selbstverständlich immer von vorne zugänglich, also über ihre Tür bzw. Türen. Eine Integration bzw. Nachrüstung der Kältemaschine dort könnte jedoch bspw. aufgrund des Zusatzgewichts und der infolgedessen erhöhten mechanischen Belastung der Türaufhängung etc. nachteilig sein.

Bevorzugte Ausgestaltungen finden sich in den abhängigen Ansprüchen und der gesamten Offenbarung, wobei bei der Darstellung der Merkmale nicht immer im Einzelnen zwischen Vorrichtungs- und Verfahrens- bzw. Verwendungsaspekten unterschieden wird; jedenfalls implizit ist die Offenbarung hinsichtlich sämtlicher Anspruchskategorien zu lesen. Wird bspw. ein für eine bestimmte Anwendung geeigneter Verteilerschrank beschrieben, ist dies auch als Offenbarung einer entsprechenden Verwendung zu lesen, und umgekehrt.

Der Aufsatz, also dessen Seitenwände und Deckelwand, kann im Allgemeinen auch aus einem Kunststoffmaterial vorgesehen sein. Bevorzugt handelt es sich um ein Metallteil, das bspw. aus miteinander verbundenen Blechteilen hergestellt ist, bspw. über Schweißverbindungen. Der Schrankkorpus weist zwei Seitenwände und eine Rückwand auf, nach vorne wird der Schrankinnenraum in Abhängigkeit von der Schrankgröße von einer oder mehreren Türen begrenzt.

Die Angaben "vorne"/"hinten" und "seitlich" beziehen sich auf die horizontale Richtung, "oben" und "unten" betreffen die vertikale Richtung, jeweils bezogen auf die Orientierung des montierten, an der Straße aufgestellten Verteilerschranks. Der Schrankkorpus kann bspw. auf einen Sockelkasten aufgesetzt sein, der im Erdreich verankert ist bzw. wird. Der Sockelkasten kann für den Eintritt der Kabel nach unten offen sein, nach oben zum Schrankinneren hin kann es bspw. einen Zwischenteil geben (mit Durchtritten für die Kabel). Auch zwischen dem Schranckorpus und dem Aufsatz kann es ein plattenförmiges Zwischenteil geben. Im Schrankinneren können neben z. B. Kassetten zum definierten Ablegen der Kabel dann auch aktive Komponenten angeordnet sein, bspw. zur Signalbearbeitung im Falle des Fernmeldenetzes.

Gemäß einer bevorzugten Ausführungsform ist die Kältemaschine derart eingerichtet, dass die Geräuschemission des ersten Wärmetauschers im maximalen Kühlbetrieb bei in der Reihenfolge der Nennung zunehmend bevorzugt höchstens 55 dB, 53 dB, 51 dB bzw. 50 dB liegt (dB meint im Rahmen dieser Offenbarung dB_{A}). Mögliche Untergrenzen der maximalen Emission können technisch bedingt bspw. bei 25 dB, 30 dB, 35dB, 40 dB, 45 dB bzw. 47 dB liegen.

Das "Eingerichtetsein" meint bspw., dass eine Steuereinheit der Kältemaschine einen Lüfter des Wärmetauschers nur unterhalb einer Maximaldrehzahl betreibt, um eine übermäßige Geräuschemission zu vermeiden. Dabei wird die maximale Geräuschemission bzw. Drehzahl im maximalen Kühlbetrieb erreicht, in anderen Betriebszuständen können Emission und Drehzahl auch geringer sein. Eine Steuereinheit der Kältemaschine kann insbesondere auch so eingerichtet sein, dass die maximale Emission/Drehzahl nur tagsüber erreicht wird, und zwar auch nur dann, wenn dies temperaturseitig erforderlich ist (siehe unten im Detail). Für den Nachtbetrieb können geringere Emissions-/Drehzahlwerte als Grenze festgelegt sein (was dann nicht der "maximale Kühlbetrieb" im vorstehenden Sinne ist).

Insgesamt kann eine geringe Geräuschemission dahingehend von Vorteil sein, dass sich der gekühlte Verteilerschrank dann bspw. auch in Wohngebieten einsetzen lässt. Wird in dem Verteilerschrank ein optisches Signal in ein elektrisches Signal umgesetzt oder umgekehrt, was eine bevorzugte Anwendung darstellt, kann so der Weg des elektrischen Signals zum Verbraucher kurz gehalten werden, lassen sich also Verluste der kupfergebundenen Übertragung auf den letzten Metern gering halten. Das vorliegende Verteilergehäuse ermöglicht aufgrund der verringerten Geräuschemission einerseits eine Positionierung nah am Endverbraucher und stellt andererseits mit der aktiven Kühlung einen zuverlässigen Betrieb sicher.

Erfindungsgemäß ist die Kältemaschine eine Kompressionskältemaschine, weist sie also einen Kältemittelkreislauf mit einem Kompressor auf. Der erste Wärmetauscher koppelt den Schrankinnenraum an den Kältemittelkreislauf, und zwar an dessen Verdampferabschnitt. Der Kondensatorabschnitt des Kältemittelkreislaufs ist bevorzugt über einen zweiten Wärmetauscher an die Umgebungsluft gekoppelt. In bevorzugter Ausgestaltung ist die Kältemaschine derart eingerichtet, dass eine maximale Geräuschemission des Kompressors und/oder zweiten Wärmetauschers im maximalen Kühlbetrieb bei höchstens 55 dB, 53 dB, 51 dB bzw. 50 dB liegt, mit möglichen Untergrenzen bei 25 dB, 30 dB, 35dB, 40 dB, 45 dB bzw. 47 dB.

Vorzugsweise ist der Kompressor vorzugsweise über Standbeine aus einem Elastomer- bzw. Gummimaterial aufgesetzt, bspw. auf den Boden einer Wanne (siehe unten). In einem allgemeineren Sinn sind dämpfende Puffer zwischen dem Kompressor und der Wanne oder einem anderen Teil, jedenfalls an dem oberen Teil des Verteilerschranks einschließlich dessen Unterbau, gehalten. Diese können auch zweistufig vorgesehen sein unter Zwischenschaltung einer Montagehilfseinrichtung, insbesondere einer Metallplatte, bspw. Stahlplatte. Dabei ist also die Montagehilfseinrichtung über dämpfende Puffer einerseits mit dem Kompressor und andererseits mit dem Gehäuse oder dem Wannenboden oder dergleichen verbunden. Hierbei kann eine Abstimmung durch die mechanischen, insbesondere elastischen Eigenschaften der Puffer und durch die (vorzugsweise relativ große) Masse der Montagehilfseinrichtung erfolgen und damit die Körperschallleitung deutlich reduziert werden. Vorzugsweise beträgt die Masse über 1.000 g, über 1.200 g, über 1.400 g, über 1.600 g oder sogar über 1.800 g.

Gemäß einer möglichen Ausführungsform ist eine Steuereinheit der Kältemaschine dazu eingerichtet, den Kompressor erst zu betreiben, wenn ein Temperaturschwellwert erreicht wird, wenn also bspw. die Außentemperatur und/oder die Temperatur im Schrankinnenraum einen Schwellenwert überschreitet. Bevorzugt wird jedenfalls die Innenraumtemperatur mit einem Temperatursensor gemessen.

Erfindungsgemäß wird in Situationen mit begrenztem Kühlbedarf, z. B. vor Erreichen des Temperaturschwellenwerts, ab welchem der Kompressor betrieben wird, bereits der erste Wärmetauscher betrieben. In diesem Betriebszustand wird der Schrankinnenraum über die Außentemperaturluft gekühlt, also gekoppelt über den ersten Wärmetauscher. Dabei könnte der erste Wärmetauscher im Allgemeinen auch direkt an die Außenluft koppeln, bevorzugt ist jedoch eine Verknüpfung über den zweiten Wärmetauscher. Über diesen wird dann, wie im Falle der Kopplung über den Kompressor, Außenluft angesaugt und Warmluft abgegeben.

Im Unterschied zu dem Kompressorbetrieb sind der erste und der zweite Wärmetauscher hierbei jedoch nicht über den Kompressor miteinander gekoppelt, sondern über einen Bypass-Kreislauf. Bevorzugt ist eine von der Steuereinheit angesteuerte Schaltventileinheit vorgesehen, mit welcher die Kopplung der Wärmetauscher zwischen dem Kompressor- und dem Bypass-Kreislauf schaltbar ist (in dem Bypass-Kreislauf kann bspw. eine einfache Pumpe für den Kältemitteltransport vorgesehen sein). Im Einzelnen kann die Schaltventileinheit mehrere schaltbare Ventile aufweisen, bspw. an Ein- und Auslass jedes Wärmetauschers jeweils ein schaltbares Zweiwegeventil, wobei ein Weg jeweils dem Kompressor- und der andere dem Bypass-Kreislauf zugeordnet ist. Der Wechsel zwischen Kompressor- und Außenlufttemperatur-Kopplung kann bspw. hinsichtlich der Energieeffizienz von Vorteil sein. Bevorzugt kann es unterhalb des Temperaturschwellwerts für den Kompressorbetrieb noch einen weiteren Temperaturschwellwert geben, unterhalb welchem dann auch die Wärmetauscher nicht betrieben werden.

Der zweite Wärmetauscher kann bspw. über ein Ausblasrohr an eine Ausblasöffnung zum Ausblasen von Warmluft angebunden sein, wobei diese Ausblasöffnung in einer Außenwand des Aufsatzes angeordnet ist. Die Warmluft wird im Betrieb nach außerhalb des Aufsatzes geführt, eine Ansaugöffnung zum Ansaugen der Umgebungsluft ist hingegen bevorzugt innerhalb des Aufsatzes angeordnet. In dessen Außenwand bzw. -wänden können Lüftungsschlitze angeordnet sein, durch welche die Umgebungsluft ins Innere des Aufsatzes strömen kann. Zusätzlich oder stattdessen saugt der zweite Wärmetauscher erfindungsgemäß Luft an aus Zwischenräumen von doppelt ausgeführten Wänden des unter der Kältemaschine vorhandenen Schrankkorpus. Damit kann eine Konvektionsströmung durch diese Zwischenräume erzeugt oder gefördert werden und die isolierende oder kühlende Wirkung solcher doppelten Wände verstärkt werden. Beispielsweise können diese Zwischenräume durch Lüftungsschlitze in den äußeren Wänden (der Doppelwände) nach außen belüftet sein, sodass das Ansaugen des zweiten Wärmetauschers mittelbar über die Zwischenräume Umgebungsluft anzieht. Dies kann übrigens auch durch das Innenvolumen des Aufsatzes geschehen, wozu dieses Innenvolumen durch entsprechende Öffnungen mit dem oder den Zwischenräumen verbunden sein kann.

Bei einer bevorzugten Ausführungsform ist der erste Wärmetauscher bzw. sind der erste und der zweite Wärmetauscher in oder oberhalb einer Wanne angeordnet. Diese Wanne hat einen Boden und einen Seitenrand, sie begrenzt ein nach oben offenes Volumen. Im Betrieb kann von dem bzw. den Wärmetauscher(n) Kondenswasser abtropfen und dient die Wanne als Auffang. Die Wanne erstreckt sich bevorzugt horizontal über die Kältemaschine hinaus, es kann bspw. eine Fläche von mindestens 100 cm², 200 cm² bzw. 300 cm² des Wannenbodens nach oben freiliegen, also nicht durch die Kältemaschine abgedeckt werden (mögliche Obergrenzen können in Abhängigkeit von den Schrankabmessungen bspw. bei höchstens 1 m² bzw. 0,5 m² liegen). Die bereichsweise nach oben freiliegende Wanne kann bspw. eine Verdunstung des Kondensats begünstigen.

Gemäß einer bevorzugten Ausführungsform ist der erste Wärmetauscher über ein Ansaug- und ein Einblasrohr an den Schrankinnenraum angebunden, durch Ersteres wird die Luft aus dem Schrankinnenraum angesaugt, durch Letzteres wieder eingeblasen. Bevorzugt ist zumindest eines der Rohre an den Wannenboden angesetzt, erfolgt die Luftführung also durch eine Öffnung im Wannenboden hindurch. Im Vergleich zu einer Luftführung seitlich an der Wanne vorbei kann dies bspw. vergrößerte Strömungsquerschnitte und damit bei gegebener Umwälzmenge verringerte Strömungsgeschwindigkeiten ergeben, was hinsichtlich der Geräuschreduktion von Vorteil sein kann.

In bevorzugter Ausgestaltung sind ein Ansaug- und/oder ein Einblasrohr, über welche der erste Wärmetauscher an den Schrankinnenraum angebunden ist, jeweils mit einem freien Strömungsquerschnitt von mindestens 300 cm² vorgesehen, wobei mindestens 350 cm² bzw. 400 cm² weiter und besonders bevorzugt sein können. Mögliche Obergrenzen können bspw. bei höchstens 700 cm², 600 cm² bzw. 500 cm² liegen und sich bspw. aus Platzgründen ergeben. Die Mindestströmungsquerschnitte, die bevorzugt jeweils über die gesamte Erstreckung des entsprechenden Rohres vorliegen, können bspw. die Strömungsgeschwindigkeiten klein halten und damit Strömungsgeräuschen vorbeugen helfen, zudem lassen sich bspw. auch die Lüfterdrehzahlen verringern, was ebenfalls geräuschmindernd wirkt.

Gemäß einer bevorzugten Ausführungsform liegen die Strömungsquerschnitte im Einsaug- und Ausblaskanal des zweiten Wärmetauschers jeweils bei mindestens 300 cm², 350 cm² bzw. 400 cm², mit möglichen Obergrenzen bei bspw. höchstens 700 cm², 600 cm² bzw. 500 cm². Es wird auf die Vorteilsangaben im vorherigen Absatz verwiesen.

Die Kältemaschine hat in bevorzugter Ausgestaltung eine Breite von höchstens 1,6 m, wobei höchstens 1,5 m bzw. 1,4 m weiter und besonders bevorzugt sind (mögliche Untergrenzen können bspw. bei 0,6 m bzw. 0,8 m liegen). Die Tiefe beträgt bevorzugt höchstens 0,5 m, mit möglichen Untergrenzen bei mindestens 0,3 m bzw. 0,4 m. Eine entsprechende Begrenzung der Breite und Tiefe kann bspw. dahingehend von Vorteil sein, dass die Kältemaschine damit zu diversen gängigen Schrankmaßen passt. Es lassen sich also unterschiedliche Schränke mit baugleichen Kältemaschinen ausstatten bzw. nachrüsten, was den Aufwand in der Fertigung bzw. bei der Montage verringern kann. Die Höhe der Kältemaschine kann bspw. höchstens 0,4 m betragen, mit möglichen Untergrenzen bei z. B. 0,2 m bzw. 0,3 m. Höhe, Breite und Tiefe der Kältemaschine werden hierbei jeweils in derselben Richtung wie im Falle des Schrankkorpus genommen (die Breite zwischen den Seitenwänden, die Tiefe zwischen Tür und Rückwand).

Ein bevorzugter Verteilerschrank kann die Form eines Quaders und bspw. eine Tiefe von 50 cm haben. Mögliche Breiten können bspw. bei 1 m, 1,4 m, 1,8 m, 2 m oder auch 2,6 m liegen. Mit dem Aufsatz und einem Sockelkasten kann die Höhe bspw. bei mindestens 1,7 m bzw. 1,8 m liegen, mit möglichen Obergrenzen bei bspw. höchstens 2,2 m bzw. 2,1 m.

Die Erfindung betrifft auch einen Satz mit mehreren Verteilerschränken, die sich dahingehend unterscheiden, dass ihre Schrankkorpusse unterschiedliche Abmessungen haben. Dies betrifft insbesondere die Breite, es wird auf die Angaben im vorherigen Absatz verwiesen. Trotz der unterschiedlich großen Schrankkorpusse sind die Verteilerschränke des Satzes jedoch baugleich hinsichtlich ihrer Kältemaschinen, sind also mit einem Typ Kältemaschine unterschiedliche Verteilerschränke ausgestattet. Dies kann die Integration und Nachrüstung vereinfachen, siehe vorne.

Die Erfindung betrifft auch die Verwendung eines vorliegend beschriebenen Aufsatzes zum Aufsetzen auf einen Schrankkorpus, um einen Verteilerschrank mit einer aktiven Klimatisierung zu versehen. Besonders bevorzugt kann eine Nachrüstung im Bestand sein, wird der Aufsatz nämlich gegen einen zuvor auf dem Schrankkorpus angeordneten Deckel ausgetauscht. Generell ist bzw. wird der Verteilerschrank bevorzugt im Freien aufgestellt, insbesondere an der Straße, also am Gehsteig bzw. Fahrbahnrand; dies soll sowohl hinsichtlich einer entsprechenden Verwendung als auch einen entsprechenden Aufbau bzw. eine entsprechende Anordnung betreffend offenbart sein.

### Kurze Beschreibung der Zeichnungen

Im Folgenden wird die Erfindung anhand eines Ausführungsbeispiels näher erläutert, wobei die einzelnen Merkmale im Rahmen der nebengeordneten Ansprüche auch in anderer Kombination erfindungswesentlich sein können und auch weiterhin nicht im Einzelnen zwischen den unterschiedlichen Anspruchskategorien unterschieden wird.

Im Einzelnen zeigt
- Figur 1: einen Verteilerschrank mit einem erfindungsgemäßen Aufsatz in einer Schrägansicht von vorne;
- Figur 2: in einer schematischen Vorderansicht die in dem Verteilerschrank gemäß Figur 1 angeordnete Kältemaschine;
- Figur 3: die Anordnung gemäß Figur 2 in einer Aufsicht;
- Figur 4: eine perspektivische Ansicht eines erfindungsgemäßen Verteilerschranks mit geöffneten Vordertüren und mit einer im oberen Bereich montierten Kältemaschine als zweites Ausführungsbeispiel;
- Figur 5: im unteren Bereich eine Draufsicht auf den Verteilerschrank aus Figur 4, jedoch nach Demontage der Kältemaschine und ohne den Innenaufbau aus Figur 4, im oberen Bereich eine Seitenansicht dazu in verkleinertem Maßstab;
- Figur 6: eine Vorderansicht des Verteilerschranks aus Figur 4, erneut ohne Innenaufbau;
- Figur 7: eine perspektivische Ansicht der in Figur 4 und Figur 6 jeweils oben sichtbaren Kältemaschine unter Weglassung des Gehäuses.

### Bevorzugte Ausführung der Erfindung

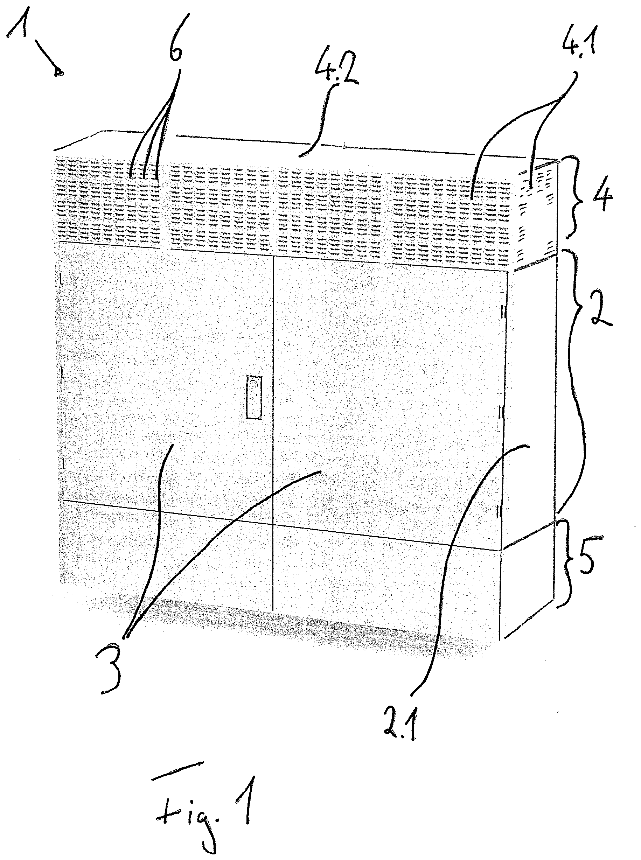

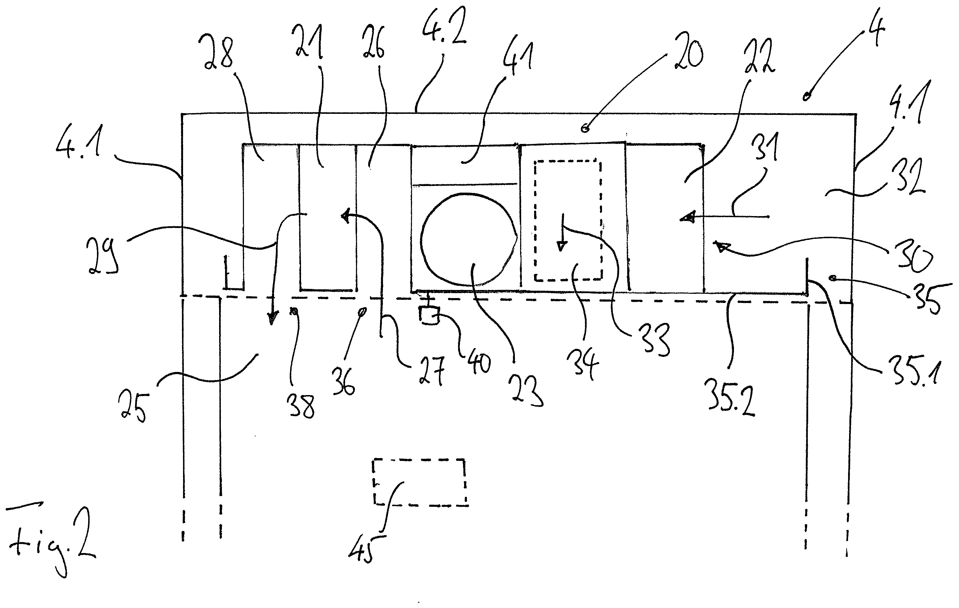

Figur 1 zeigt einen Verteilerschrank 1 in einer Schrägansicht von vorne. Dieser weist einen Schrankkorpus 2 auf, von dem in der Schrägansicht eine Seitenwand 2.1 zu erkennen ist. Der Schrankkorpus 2 begrenzt einen Schrankinnenraum (siehe Figur 2), dieser ist über zwei vorderseitig angeordnete Türen 3 zugänglich. Auf dem Schrankkorpus 2 ist ein Aufsatz 4 angeordnet, der Schrankkorpus 2 sitzt seinerseits auf einem Sockelkasten 5.

In der Darstellung gemäß Figur 1 sind zwei Seitenwände 4.1 des Aufsatzes zu erkennen, die jeweils mit einer Vielzahl Belüftungsschlitzen 6 versehen sind. Auf den Seitenwänden 4.1 ist eine Deckelwand 4.2 angeordnet, vorliegend handelt es sich um miteinander schweißverbundene Blechteile.

Figur 2 zeigt in einer schematischen Detailansicht das Innenleben des Aufsatzes 4, nämlich eine Kältemaschine 20. Diese weist einen ersten Wärmetauscher 21 und einen zweiten Wärmetauscher 22 auf. Dazwischen ist zur Kompression eines Kältemittels in einem Kältemittelkreislauf (nicht im Einzelnen dargestellt) ein Kompressor 23 angeordnet. Bei dieser Kompressionskältemaschine wird das Kältemittel in dem Kompressor 23 komprimiert und anschließend in einem Verflüssigerabschnitt in dem zweiten Wärmetauscher 22 unter Wärmeabgabe kondensiert. Über eine Drossel gelangt das flüssige Kältemittel in einen Verdampferabschnitt im ersten Wärmetauscher 21, wo es unter Wärmeaufnahme verdampft.

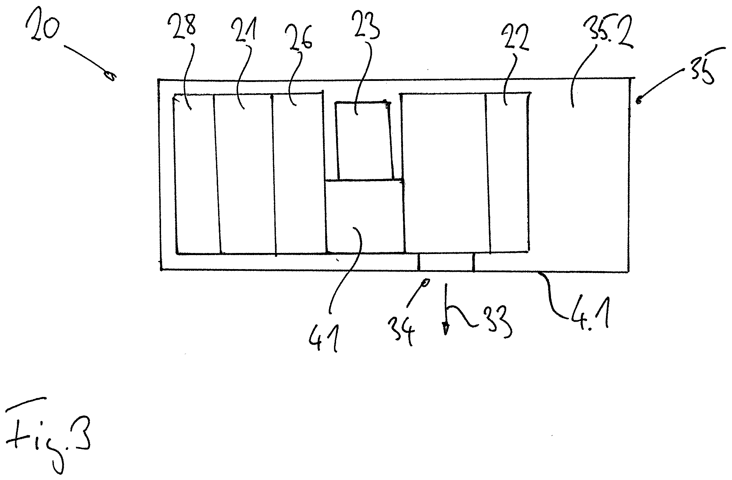

Der erste Wärmetauscher 21 ist an den Schrankinnenraum 25 gekoppelt, über ein Ansaugrohr 26 wird Ansaugluft 27 aus dem Schrankinnenraum 25 angesaugt. Nach der Abkühlung in dem ersten Wärmetauscher 21 wird diese Luft über ein Einblasrohr 28 als Einblasluft 29 wieder in den Schrankinnenraum 25 eingeblasen. Dieser wird somit über einen in sich geschlossenen Luftkreislauf gekühlt. Der zweite Wärmetauscher 22 saugt über eine Ansaugöffnung 30 Umgebungsluft 31 im Innenraum 32 des Aufsatzes 4 an, diese kann über die Lüftungsschlitze 6 einströmen (Figur 1). Nach der Erwärmung in dem zweiten Wärmetauscher 22 wird die Warmluft 33 an einer Ausblasöffnung 34 ausgeblasen, die in einer Seitenwand 4.1 des Aufsatzes 4 angeordnet ist (siehe Figur 3). Alternativ könnte der Innenraum 32 des Aufsatzes 4 mit einem Schott in Bereiche unterteilt sein (nicht dargestellt), wobei in einem der Bereiche angesaugt und in einem anderen ausgeblasen wird (über Lüftungsschlitze gelangt die Luft von außerhalb des Aufsatzes in den einen Bereich bzw. aus dem anderen Bereich nach außen).

Wie in der Beschreibungseinleitung im Einzelnen diskutiert, sind die Strömungsquerschnitte bei der Führung der Ansaug- bzw. Einblasluft 27, 29, sowie auch der Umgebungsluft 31 und Warmluft 33 vergleichsweise groß bemessen, sodass mit im Verhältnis verringerten Lüfterdrehzahlen die benötigte Umwälzmenge erreicht werden kann, was hinsichtlich der Geräuschverringerung von Vorteil ist. Wie aus Figur 2 ersichtlich ist die Kältemaschine 20 in einer Wanne 35 angeordnet, die mit Seitenwänden 35.1 und einer Bodenwand 35.2 ein nach oben offenes Volumen begrenzt. In diesem kann sich Kondenswasser sammeln, das anschließend wieder verdunsten kann. Um mit dem Ansaug- und Einblasrohr 26, 28 die gewünschten großen Strömungsquerschnitte realisieren zu können, sind diese Rohre 26, 28 an Öffnungen 36, 38 in dem Boden 35.2 der Wanne 35 angesetzt.

In Figur 2 ist in dem Schrankinnenraum 25 ferner ein Temperatursensor 40 zu erkennen, der mit einer Steuereinheit 41 der Kältemaschine 20 gekoppelt ist. Die Steuereinheit 41, die Logik- und Treiberbausteine umfasst (nicht im Einzelnen dargestellt), ist derart eingerichtet, dass der Kompressor 23 erst dann betrieben wird, wenn die Temperatur in dem Schrankinnenraum 25 einen bestimmten Schwellwert übersteigt. In einem Temperaturregime darunter, also unterhalb dieses oberen Schwellwerts, aber oberhalb eines unteren Schwellwerts, wird der Schrankinnenraum passiv über die Temperatur der Umgebungsluft 31 gekühlt. Dazu werden die beiden Wärmetauscher 21, 22 über eine Schaltventileinheit (nicht dargestellt) direkt miteinander verbunden, wird der Kompressor 23 also mit einem Bypass umgangen. Damit kann, solange die Temperatur in dem Schrankinnenraum 25 nicht zu hoch wird, mit verringertem Energieeinsatz gekühlt werden.

In Figur 2 ist eine der in dem Schrankinnenraum 25 untergebrachten Komponenten schematisch gezeigt, nämlich eine Wandlereinheit 45 zum Umsetzen eines optischen Signals in ein elektrisches Signal oder umgekehrt. Ferner werden in dem Verteilerschrank 1 Elemente zum Verzweigen bzw. Ablegen etc. der Kabel angeordnet (nicht im Einzelnen dargestellt).

Figur 3 zeigt einen Teil der Anordnung gemäß Figur 2 in einer Aufsicht, zu erkennen sind der erste Wärmetauscher 21 mit dem Ansaug- und dem Einblasrohr 26, 28, sowie der zweite Wärmetauscher 22 und der liegend montierte Kompressor 23, über dem die Steuereinheit 41 angeordnet ist. Zu erkennen ist insbesondere auch die in die Außenwand 4.1 des Aufsatzes 4 integrierte Ausblasöffnung 34, über welche die Warmluft 23 abgeführt wird. Die Wanne 35 erstreckt sich weiter als die Kältemaschine 20, sodass es zur Begünstigung der Verdampfung des Kondensats einen nach oben freiliegenden Bereich gibt.

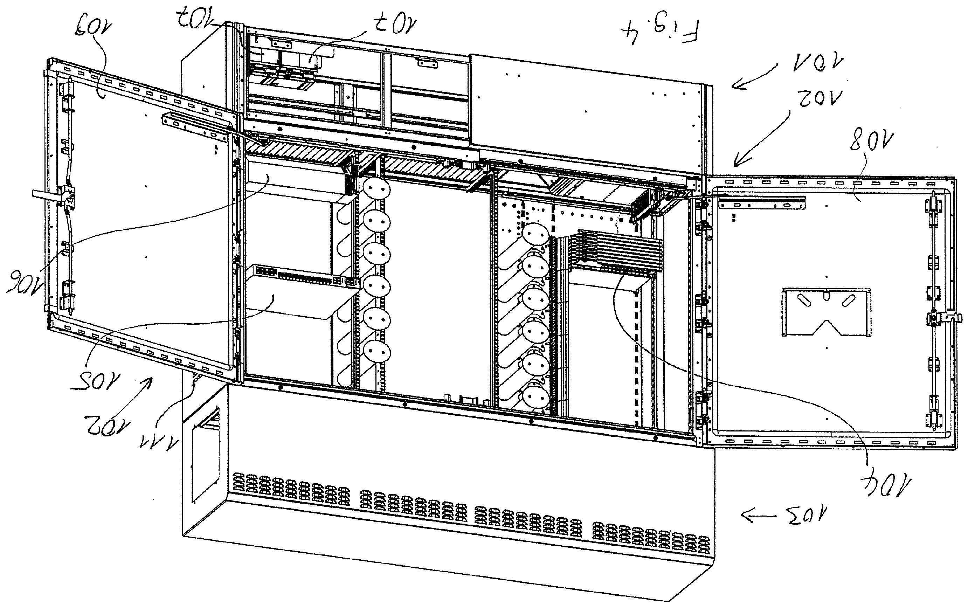

In Figur 4 erkennt man ein zweites Ausführungsbeispiel, nämlich einen Verteilerschrank für Glasfaserkabel-Installationen. Das Gehäuse des Verteilerschranks (also der Schrankkorpus) weist einen unteren Teil 101, einen mittleren Teil 102 und einen oberen Teil 103, also einen Aufsatz, auf. Der untere Teil 101 dient zum Einführen von z. B. aus dem Boden unter dem Verteilerschrank aufsteigenden Glasfaserkabelbündeln, die dann, in einzelne Stränge aufgeteilt, in an sich bekannter Form durch im Wesentlichen horizontal verlaufende Zwischenelemente zwischen dem unteren Teil 101 und dem mittleren Teil 102 hindurchtreten. Im mittleren Teil 102 ist links eine Moduleinheit 104 mit einer Mehrzahl übereinander gestapelter Spleiß- und Patchmodule dargestellt. Im rechten Bereich ist eine aktive elektronische Baugruppe dargestellt, weiter unten eine Notstromversorgung 106, deren Batterie 107 im unteren Teil rechts dargestellt ist. Alle diese Elemente sind exemplarisch und, was die Elemente 104 und 105 betrifft, in relativ kleiner Zahl dargestellt. Weitere Elemente dienen dem sogenannten Kabelmanagement, also der geordneten geometrischen Führung einer Vielzahl von hier nicht eingezeichneten Glasfaserkabeln und sind an sich bekannt.

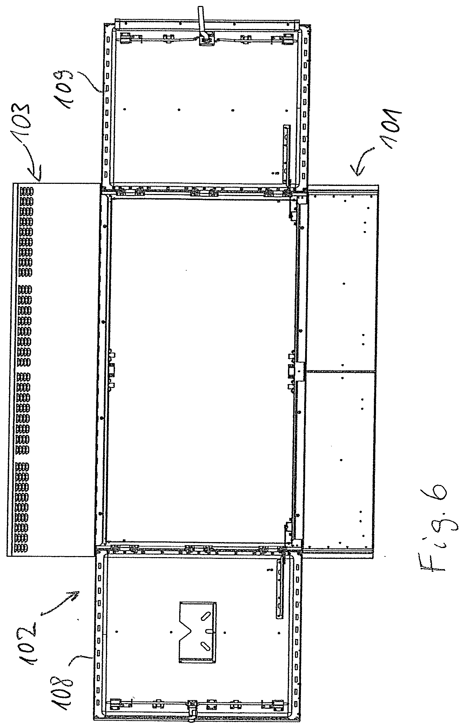

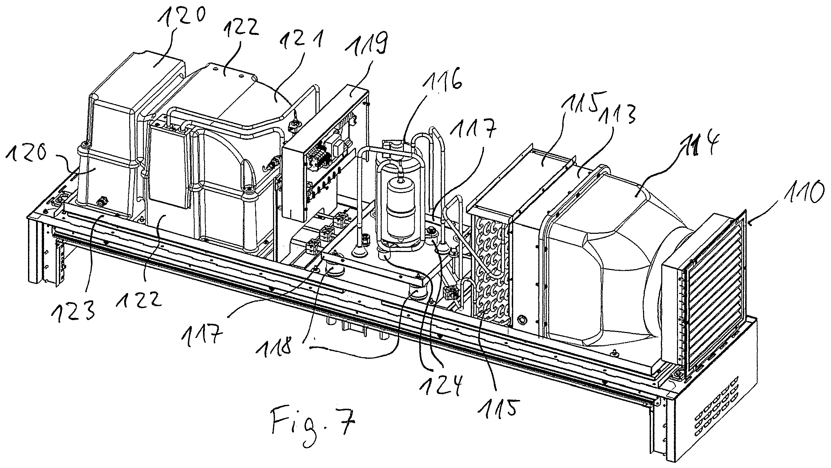

Der mittlere Teil ist nach vorn durch zwei in den Figuren offenstehende Türen 108 und 109 verschließbar. Er endet im oberen Bereich in einer anhand Figur 2 noch näher zu erläuternden horizontalen Abtrennung, über der der obere Teil 103 mit einer Kältemaschine dargestellt ist. Diese Kältemaschine ist in einem Gehäuse mit Blechwänden untergebracht und, was den inneren technischen Teil betrifft, in Figur 4 näher dargestellt. Das Blechgehäuse weist an seiner rechten Stirnseite in dem quadratischen Ausschnitt in Figur 4 und 6 einen in Figur 7 rechts dargestellten Einsatz 110 mit durch Lamellen getrennten Schlitzöffnungen zum Abführen von Abluft bzw. Abwärme und im Übrigen in Figur 4 und 6 nach vorn weisend kleine Lüftungsöffnungen auf.

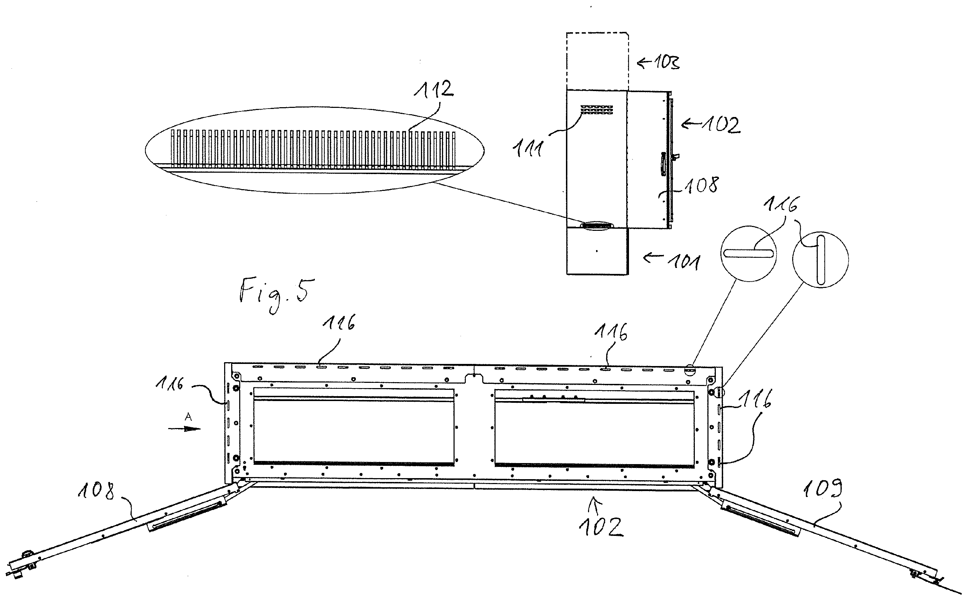

Ähnliche Belüftungsöffnungen finden sich mit dem Bezugszeichen 111 in der rechten Seitenwand des mittleren Teils 102 in Figur 4 und, auf der entgegengesetzten Seite, in der Seitenansicht in Figur 5 oben. Diese dienen zur Belüftung eines jeweiligen seitlichen Zwischenraums, denn die beiden entsprechenden Seitenwände des mittleren Teils 10 des Verteilerschranks sind doppelwandig. Das gilt auch, wenngleich nicht in den Zeichnungen zu erkennen, für die in den Figuren 4 und 6 nach hinten weisende Rückseite. Weitere Belüftungsöffnungen 112 findet man im unteren Bereich der beiden Seitenwände und der Rückwand, vergleiche Figur 5 oben einschließlich der vergrößerten Darstellung oben links.

Im Prinzip könnte man die Zwischenräume also durch eine passive Konvektionsströmung kühlen, weil die beschriebenen Belüftungsöffnungen 111 und 112 auf sehr unterschiedlichen Höhen angeordnet sind. Erfindungsgemäß ist jedoch zusätzlich eine Zwangsströmung durch diese Zwischenräume vorgesehen, und zwar unter Verwendung eines Kondensatorlüfters 113 der in Figur 7 näher dargestellten Kältemaschine.

In Figur 7 erkennt man den gerade erwähnten Kondensatorlüfter 113 der Kältemaschine rechts. Er ist über ein trichterartiges Luftführungsgehäuse 114 angeschlossen an den bereits erwähnten Einsatz 110 zum Abführen der warmen Abluft. Links von dem Kondensatorlüfter 113 erkennt man die diesem zugeordneten Wärmetauscherschlangen des Kältemittelkreislaufs, wobei diese Einheit mit 115 bezeichnet ist. Der Kondensatorlüfter 113 zieht als Axiallüfter Luft aus dieser Einheit 115 an (und führt sie über das Luftführungsgehäuse 114 und den Einsatz 110 nach außen), wobei diese Luft aus dem Innenvolumen des Gehäuses der gesamten Kältemaschine angesaugt wird. In dieses Innenvolumen wird sie nachgeführt durch an den Oberseiten der jeweiligen Zwischenräume der Seitenwände und der Hinterwand angebrachte schlitzartige Öffnungen 116, vergleiche Figur 5, sodass in den Zwischenräumen eine Zwangsströmung entsteht und durch die bereits zuvor erwähnten Belüftungsöffnungen 111 Außenluft nachgeführt wird.

Außerdem zeigen die Figuren 4 und 63 vorderseitige Belüftungsschlitze an dem Gehäuse der Kältemaschine, durch welche Lüftungsschlitze ebenfalls Luft nachgeführt wird. Dies beeinträchtigt den Kühleffekt der bereits erläuterten erzwungenen Konvektionsströmung nicht wesentlich. Allerdings ist durch diese Belüftungsschlitze des Gehäuses der Kältemaschine der Gesamtquerschnitt der Zuluft für den Kondensatorlüfter 113 vergrößert, was ihm im Vollbetrieb des Kompressors 116 und des Kältemittelkreislaufs zugutekommt. In diesem Vollbetrieb wäre die Belüftung allein über die Zwischenräume der doppelten Seitenwände etwas knapp. Natürlich könnte man die Größe und Zahl der Öffnungen zwischen diesen Zwischenräumen und dem Gehäuse der Kältemaschine vergrößern, um ein ähnliches Ergebnis zu erzielen.

Die Platte 117 hat zwar, wie Figur 7 andeutet, eine Wannenform (ähnlich wie die Grundplatte der gesamten Kältemaschine) zum Auffangen von etwaigem Kondensat; es handelt sich aber zusätzlich um eine bewusst massereich ausgeführte Stahlplatte von ungefähr 2.000 g. Dieses Gewicht wird abhängig von der Masse des Kompressors und den mechanischen Eigenschaften der Elastomerfüße 118 und 114 empirisch ermittelt und spielt bei der Körperschallunterdrückung eine Rolle.

Links von dem Kondensatorblock aus den Elementen 113, 114 und 115 ist ein Kältekompressor 116 eingezeichnet, der auf einer separaten Montageplatte 117 mit schwingungsabsorbierenden Elastomerfüßen 118 steht. Dabei ist die Montageplatte 117 ungefähr quadratisch mit vier Elastomerfüßen 118 montiert, wobei der Kompressor 116 selbst auf in diesem Fall drei weiteren (kleineren) schwingungsabsorbierenden Elastomerfüßen 124 steht und über diese an die Montageplatte 117 gekoppelt ist. Bei einer anderen bevorzugten Ausgestaltung kann auch diese Verbindung mit vier Elastomerfüßen1 24 ausgeführt sein, dann also mit einer eher quadratischen statt dreieckigen Geometrie.

Noch weiter links erkennt man eine elektronische Mikro-Controller-Steuerung 119 und links davon einen Verdampferblock, dessen linker Teil ein radial wirkender Verdampferlüfter 120 ist. Dieser ist unterseitig durch eine Öffnung an das Innenvolumen des Verteilerschranks angeschlossen (nicht an den Zwischenraum der linken Seitenwand). Rechts von dem Verdampferlüfter gibt es einen Luftführungskasten 121, der über eine weitere unterseitige Öffnung an den Innenraum des Verteilerschranks angeschlossen ist. Dazwischen liegt ein Block Wärmetauscherschlangen 122 des Kältmittelkreislaufs. Damit kann der Verdampferlüfter 120 einerseits (z. B. von unten) Innenraumluft ansaugen und andererseits (z. B. über den Luftführungskasten 121) Luft wieder in den Innenraum zurückführen. Bereits ohne Betrieb des Kältemittelkreislaufs bzw. des Kompressors 116 kann der Verdampferlüfter 120 damit in einer bereits beschriebenen Weise die Innenraumluft umwälzen und durchmischen.

Bei den beiden Lüftern handelt es sich um EC-Lüfter mit steuerbarer Drehzahl. Damit können die Lüfter im Betrieb des Kältemittelkreislaufs und auch außerhalb dessen mit unterschiedlicher Leistung und damit nur der unvermeidlichen Geräuschemission betrieben werden.

Die gesamte erläuterterte Technik ist (zusätzlich zu der schwingungabsorbierenden Lagerung der Platte 117 und des Kompressors 116) auf einer eigenständigen Montageplatte 123 aufgebaut, die ihrerseits über weitere schwingungsabsorbierende Elastomerfüße auf der in Figur 5 sichtbaren Oberseite des mittleren Teils 102 des Verteilerschranks aufgesetzt ist.

Figur 7 zeigt im Bereich des Luftführungskastens 121 und des Wärmetauscherschlangenblocks 122 sowie um den Kompressor 116 herum und von dort aus zu dem Wärmetauscherschlangenblock 115 verschiedene weitere weitgehend frei verlaufende Leitungsabschnitte von Rohrleitungen des Kältemittelkreislaufs. Diese Leitungen sind an manchen Stellen, etwa in Figur 7 links von der Platte 117 und auch rechts davon sowie im Durchgang durch die Platte 117, in einer schwingungsabsorbierenden Weise unter Zwischenschaltung von Elastomerteilen gestützt. Im Übrigen sind sie aber gezielt an bestimmten Stellen durch Gewichte beschwert, was Figur 7 nicht im Einzelnen darstellt. Damit können Resonanzfrequenzen beeinflusst und insbesondere verringert werden und kann das Gesamtschwingungsverhalten des Leitungssystems verbessert werden.

Ohne wesentlichen Kühlbedarf bleiben die einzelnen Elemente der Kältemaschine außer Funktion und wird der Verteilerschrank, insbesondere sein mittlerer Teil 102, in an sich konventioneller Weise durch Abstrahlung und durch eine passive Konvektion der Luft in den Zwischenräumen der Doppelwände gekühlt. Bei steigendem Kühlbedarf kann der Kältemittelkreislauf, insbesondere der Kompressor 116, zunächst außer Betrieb bleiben und damit eine erhebliche Einsparung an Geräuschemission und Energieverbrauch erzielt werden, indem zunächst zumindest einer der beiden beschriebenen Lüfter 113 und 120 benutzt wird. Der Kondensatorlüfter 113 führt dabei zu einer verstärkten Zwangsluftströmung durch die Zwischenräume und der Verdampferlüfter 120 durchmischt die Innenraumluft und verteilt damit die anfallende Abwärme gleichmäßiger. Damit werden insbesondere lokale Temperaturspitzen an kritischen Stellen, insbesondere bei Leistungsbauteilen, vermieden. Je nach Einzelfall kann natürlich zunächst nur einer der beiden Lüfter 113 und 120 benutzt werden, wobei natürlich auch die Drehzahl der Lüfter 113 und 120 angepasst werden kann, und zwar zusätzlich oder alternativ.

Bei weiter steigendem Kühlbedarf werden der Kompressor 116 und damit der Kältemittelkreislauf eingeschaltet. Die beschriebenen Wirkungen bleiben erhalten, jedoch ist die von dem Verdampferlüfter in den Innenraum zurückgeführte Luft dann aktiv gekühlt. Der Kältemittelkreislauf transportiert die Abwärme zu dem Wärmetauscher 115 des Kondensatorlüfters, sodass die dort dann anfallende Abwärme über den Kondensatorlüfter 113, das Luftführungsgehäuse 114 und den Einsatz 110 nach außen abgeführt wird. Sowohl die Durchmischung durch den Verdampferlüfter 120 als auch die saugende Konvektionsunterstützung in den Zwischenräumen sind besonders effektiv, weil beide Lüfter mit der Kältemaschine über dem zu kühlenden Innenraum angeordnet sind.

Der Kühlbedarf entsteht typischerweise nicht durch in dem Verteilerschrank verbaute Glasfaserinstallationen und zugeordnete passive Komponenten, sondern durch aktive optoelektronische Komponenten und elektronische Schaltungen, wie sie in der beispielhaft eingezeichneten Baugruppe 105 vorhanden sind. Die elektronischen Komponenten sind typischerweise auch die temperaturempfindlichsten Bauteile. Insoweit ist die Anordnung der Komponenten in Figur 7 in Anbetracht der Anordnung der Baugruppe 105 in Figur 4 rechts nicht ganz optimal (und gehört gewissermaßen zu einem rechts/links-vertauschten Beispiel). Sinnvollerweise werden die temperaturerzeugenden und die temperaturempfindlichsten Bauteile und -gruppen möglichst unter dem Verdampferlüfter 120 angeordnet, weil dieser im aktiven Kühlbetrieb nicht nur Warmluft abführt und aktiv gekühlte Kaltluft nach unten befördert, sondern andererseits auch im reinen Lüfterbetrieb am wirksamsten einer Temperaturspitze durch einen Wärmestau entgegenwirkt.

Für einen möglichen Stromausfall sollen solche Leitungsinstallationen einschließlich der optoelektronischen und elektronischen Komponenten wie in dem Element 105 zumindest in einem Notbetrieb weiterlaufen. Daher ist eine Notstromversorgung 106 mit einer Batterie 107 vorgesehen, die erfindungsgemäß so ausgelegt ist, dass damit zumindest einer der beiden beschriebenen Lüfter 113, 120 der Kältemaschine, vorzugsweise beide, weiter betrieben werden kann. So kann für diesen Notbetrieb eine verbesserte Basiskühlfunktion bereitgestellt werden, die in aller Regel ausreichen dürfte, weil der Notbetrieb typischerweise einen verkleinerten Wärmeanfall mit sich bringt.

Im Übrigen kann der Betrieb der Lüfter und der gesamten Kältemaschine durch entsprechende Temperatursensoren an charakteristischen Stellen temperaturgesteuert oder auch einfach (aufgrund empirischer Befunde) tageszeitgesteuert erfolgen. Bei einer typischen Aufstellung des Verteilerschranks im Freien oder jedenfalls unter Sonneneinwirkung können die beschriebenen Komponenten nachts z. B. außer Betrieb bleiben, könnte nach Sonnenaufgang im Verlauf des Vormittags zunächst z. B. eine reine Lüfterfunktion aufgenommen werden und könnte dann z. B. gegen Mittag und bis z. B. zum späten Nachmittag die aktive Kühlung mit dem Kältemittelkreislauf und dem Kompressor 116 laufen. Dann könnte in den Abend hinein wieder auf einen reinen Lüfterbetrieb umgeschaltet und am späteren Abend auch dieser eingestellt werden.

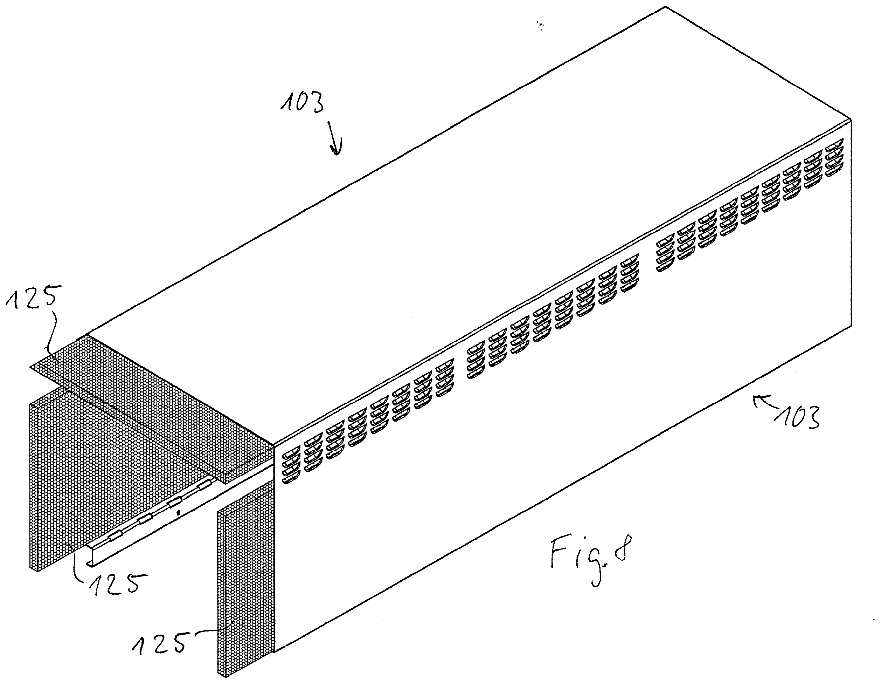

Figur 8 zeigt den oberen Gehäuseteil 3 aus den Figuren 4 bis 6 für sich und ohne Seitenteile (stirnseitig). Dabei sind zur Veranschaulichung am linken Ende innere akustische Plattenbeschichtungen 125 dargestellt (die tatsächlich natürlich nur innerhalb der Blechwände vorliegen). Es handelt sich dabei tatsächlich um Mehrschichtplatten 125, die einerseits relativ schwere Schichten außen (Schwerfolie) und andererseits nach weiter innen zunehmend leichtere Schichten mit außerdem dämmender Funktion sind. Solche Beschichtungen sind innerhalb des Gehäuseteils 13 mit Ausnahme der Bereiche mit den Belüftungsschlitzen (wie in Figur 8 dargestellt und außerdem an der rechten Seite der Figuren 4 bis 6) im wesentlichen vollständig vorgesehen, also oben, hinten, vorn und links. Auch damit lässt sich die Geräuschemission wirksam reduzieren.

## Patentansprüche

1. Verteilerschrank für den Außenbereich, mit
einem Schrankkorpus (2), der einen Schrankinnenraum (25) begrenzt, einer Tür (3), über welche der Schrankinnenraum (25) zugänglich ist, und einem Aufsatz (4), der auf dem Schrankkorpus (2) angeordnet ist,
wobei der Verteilerschrank (1) zur Kühlung des Schrankinnenraums (25) eine Kältemaschine (20) mit einem ersten Wärmetauscher (21) aufweist,
wobei die Kältemaschine (20) in dem Aufsatz (4) angeordnet ist und über den ersten Wärmetauscher (21) an den Schrankinnenraum (25) gekoppelt ist und ein Lüfter (120) des ersten Wärmetauschers mit seiner Ansaugseite und seiner Ausstoßseite an den Innenraum des Verteilerschranks (102) angeschlossen ist und zur Verwirbelung einer Temperaturschichtung darin ausgelegt ist,
**dadurch gekennzeichnet, dass** der Lüfter (120) in Situationen mit Kühlbedarf bei ausgeschaltetem Kompressor (116) der Kältemaschine (113-123) und in Situationen mit höherem Kühlbedarf als Verdampferlüfter (120) der Kältemaschine (113-123) bei eingeschaltetem Kompressor (116) der Kältemaschine (113-123) betrieben werden kann und
dass ein Lüfter (113) des zweiten Wärmetauschers an zumindest einen Zwischenraum von Gehäusewänden des Schrankkorpus, welche zwischen einer Innenwand und einer weiteren Außenwand den Zwischenraum abgrenzen, angeschlossen ist und im Betrieb eine Luftströmung durch den Zwischenraum zur Kühlung eines Innenraums des Verteilerschranks (1) erzwingt.

2. Verteilerschrank nach einem der vorstehenden Ansprüche, bei welchem der zweite Wärmetauscher (22) an eine Ansaugöffnung (30) zum Ansaugen von Umgebungsluft (31) und eine Ausblasöffnung (34) zum Ausblasen von Warmluft (33) angebunden ist, wobei die Ansaugöffnung (30) innerhalb eines von dem Aufsatz (4) begrenzten Innenraums (32) angeordnet sind.

3. Verteilerschrank nach einem der vorstehenden Ansprüche, bei welchem der oder die Wärmetauscher (21,22) in dem Aufsatz (4) in oder oberhalb einer Wanne (35) angeordnet ist bzw. sind.

4. Verteilerschrank nach einem der vorstehenden Ansprüche, bei welchem der erste Wärmetauscher (21) über ein Ansaug- und ein Einblasrohr (26,28) an den Schrankinnenraum (25) angebunden ist, wobei ein freier Strömungsquerschnitt in den Rohren (26,28) jeweils mindestens 300 cm² beträgt.

5. Verteilerschrank nach einem der vorstehenden Ansprüche, bei dem ein Kompressor (116) der Kältemaschine (113-123) mittels dämpfenden, vorzugsweise elastischen Puffern (124) an einer starren Montagehilfseinrichtung (117) gelagert ist, welche Montagehilfseinrichtung (117) ihrerseits mittels weiteren dämpfenden, vorzugsweise elastischen Puffern (118) an dem Verteilerschrank (102) gelagert ist.

6. Verteilerschrank nach Anspruch 5, bei dem die Montagehilfseinrichtung (117) eine Masse von mindestens 700 g aufweist und vorzugsweise eine Platte, insbesondere eine Metallplatte, insbesondere eine Stahlplatte ist.

7. Verteilerschrank nach einem der vorstehenden Ansprüche, in dem eine optische Wandlereinheit (45) zur Umsetzung eines optischen Signals in ein elektrisches Signal angeordnet ist.

8. Verteilerschrank nach einem der vorstehenden Ansprüche, bei welchem die Kältemaschine (20) eine Breite von höchstens 1,4 m und eine Tiefe von höchstens 0,5 m hat.

9. Satz mit einer Mehrzahl Verteilerschränke nach einem der vorstehenden Ansprüche, wobei sich die Verteilerschränke des Satzes in den Abmessungen ihrer Schrankkorpusse (2) unterscheiden, hinsichtlich ihrer Kältemaschinen (20) aber baugleich sind.

10. Verwendung eines Aufsatzes (4), der eine Kältemaschine (20) mit einem ersten Wärmetauscher (21) aufweist, zum Aufsetzen auf einen Schrankkorpus (2), um einen Verteilerschrank nach einem der Ansprüche 1 bis 8 herzustellen.

11. Verwendung nach Anspruch 10, bei welcher der Aufsatz (4) nachgerüstet wird, nämlich gegen einen zuvor auf dem Schrankkorpus (2) angeordneten Deckel ausgetauscht wird.

12. Verwendung eines Verteilerschranks nach einem der Ansprüche 1 bis 8 außerhalb eines Gebäudes im Freien.

## Claims

1. Distribution cabinet for outdoor use, comprising:
a cabinet body (2) delimiting a cabinet interior (25),
a door (3) through which the cabinet interior (25) is accessible, and
an attachment (4) arranged on the cabinet body (2),
wherein the distribution cabinet (1) has a refrigerating machine (20) with a first heat exchanger (21) for cooling the cabinet interior (25),
wherein the refrigerating machine (20) is arranged in the attachment (4) and is coupled to the cabinet interior (25) via the first heat exchanger (21), and a fan (120) of the first heat exchanger is connected with its intake side and its discharge side to the interior of the distribution cabinet (102) and is designed for turbulence of a thermal stratification therein,
**characterised in that** the fan (120) is operable in situations with cooling needs when the compressor (116) of the refrigerating machine (113-123) is switched off and is operable as an evaporator fan (120) of the refrigerating machine (113-123) in situations with higher cooling needs when the compressor (116) of the refrigerating machine (113-123) is switched on, and
that a fan (113) of the second heat exchanger is connected to at least one intermediate space between housing walls of the cabinet body which delimit the intermediate space between an inner wall and a further outer wall, and induces, in operation, an air flow through the intermediate space for cooling an interior space of the distribution cabinet (1).

2. Distribution cabinet according to claim 1, wherein the second heat exchanger (22) is connected to an intake opening (30) for drawing in ambient air (31) and a blow-out opening (34) for blowing out warm air (33), wherein the intake opening (30) is arranged within an interior space (32) delimited by the attachment (4).

3. Distribution cabinet according to one of the preceding claims, wherein the heat exchanger or heat exchangers (21, 22) in the attachment (4) is/are arranged on or above a tray (35).

4. Distribution cabinet according to one of the preceding claims, wherein the first heat exchanger (21) is connected to the cabinet interior (25) via an intake pipe and an injection pipe (26, 28), wherein a respective free flow cross-section in the pipes (26, 28) is at least 300 cm².

5. Distribution cabinet according to one of the preceding claims, wherein a compressor (116) of the refrigerating machine (113-123) is supported on a rigid assembly auxiliary device (117) by means of damping buffers (124) which are preferably elastic, which assembly auxiliary device (117) in turn is supported on the distribution cabinet (102) by means of further damping buffers (118) which are preferably elastic.

6. Distribution cabinet according to claim 5, wherein the assembly auxiliary device (117) has a mass of at least 700 g and is preferably a plate, in particular a metal plate, in particular a steel plate.

7. Distribution cabinet according to one of the preceding claims, in which an optical converter unit (45) for converting an optical signal into an electrical signal is arranged.

8. Distribution cabinet according to one of the preceding claims, wherein the refrigerator (20) has a width of at most 1.4 m and a depth of at most 0.5 m.

9. Set with a plurality of distribution cabinets according to one of the preceding claims, wherein the distribution cabinets of the set differ in the dimensions of their cabinet bodies (2), but are structurally identical in terms of their refrigerating machines (20).

10. Use of an attachment (4) comprising a refrigerating machine (20) with a first heat exchanger (21), for mounting on a cabinet body (2) in order to produce a distribution cabinet according to one of claims 1 to 8.

11. Use according to claim 10, wherein the attachment (4) is retrofitted, namely replacing a cover previously arranged on the cabinet body (2).

12. Use of a distribution cabinet according to one of claims 1 to 8 outside a building, outdoors.

## Revendications

1. Armoire de distribution à usage extérieur, comportant :
un corps d'armoire (2) délimitant l'intérieur (25) de l'armoire,
une porte (3) permettant d'accéder à l'intérieur (25) de l'armoire, et
un module rapporté (4) agencé sur le corps d'armoire (2) ;
ladite armoire de distribution (1) comportant une machine frigorifique (20) qui est destinée à refroidir l'intérieur (25) de l'armoire et qui présente un premier échangeur de chaleur (21),
ladite machine frigorifique (20) étant disposée dans le module rapporté (4) et étant couplée audit intérieur (25) de l'armoire par le biais du premier échangeur de chaleur (21), et un ventilateur (120) du premier échangeur de chaleur étant relié par son côté aspiration et son côté refoulement audit intérieur de ladite armoire de distribution (102) et étant conçu pour un effet de turbulence sur une stratification thermique dans ledit intérieur,
**caractérisée en ce que** le ventilateur (120) peut être exploité dans des situations demandant un refroidissement tandis que le compresseur (116) de la machine frigorifique (113-123) est éteint et peut être exploité comme ventilateur d'évaporateur (120) de la machine frigorifique (113-123) dans des situations demandant un plus fort refroidissement tandis que le compresseur (116) de la machine frigorifique (113-123) est en marche
et qu'un ventilateur (113) du deuxième échangeur de chaleur est relié à au moins un espace intermédiaire créé par des parois de logement du corps d'armoire qui délimitent l'espace intermédiaire entre une paroi intérieure et une paroi plus extérieure, et cause, en fonctionnement, un flux d'air à travers ledit espace intermédiaire pour refroidir un espace intérieur de l'armoire de distribution (1).

2. Armoire de distribution selon la revendication 1, dans laquelle le deuxième échangeur de chaleur (22) est raccordé à une ouverture d'aspiration (30) pour aspirer de l'air ambiant (31) et à une ouverture de soufflage (34) pour souffler de l'air chaud (33), ladite ouverture d'aspiration (30) étant disposée à l'intérieur d'un espace (32) délimité par le module rapporté (4).

3. Armoire de distribution selon l'une des revendications précédentes, dans laquelle le ou les échangeurs de chaleur (21, 22) présents dans le module rapporté (4) sont disposés dans ou au-dessus d'un bac (35).

4. Armoire de distribution selon l'une des revendications précédentes, dans laquelle le premier échangeur de chaleur (21) est relié à l'intérieur (25) de l'armoire par une tubulure d'aspiration et une tubulure d'injection (26, 28), la section d'écoulement libre desdites tubulures (26, 28) étant respectivement d'au moins 300 cm².

5. Armoire de distribution selon l'une des revendications précédentes, dans laquelle un compresseur (116) de la machine frigorifique (113-123) est monté sur un dispositif auxiliaire d'assemblage (117) rigide au moyen de tampons amortisseurs (124) de préférence élastiques, lequel dispositif auxiliaire d'assemblage (117) est lui-même monté sur l'armoire de distribution (102) au moyen de tampons amortisseurs (118) supplémentaires de préférence élastiques.

6. Armoire de distribution selon la revendication 5, dans laquelle le dispositif auxiliaire d'assemblage (117) a une masse d'au moins 700 g et consiste de préférence en une plaque, notamment métallique, notamment en acier.

7. Armoire de distribution selon l'une des revendications précédentes, dans laquelle **il** est disposé une unité de convertisseur optique (45) pour convertir un signal optique en un signal électrique.

8. Armoire de distribution selon l'une des revendications précédentes, dans laquelle la machine frigorifique (20) a une largeur d'au plus 1,4 m et une profondeur d'au plus 0,5 m.

9. Ensemble constitué d'une pluralité d'armoires de distribution selon l'une des revendications précédentes, dans lequel les armoires de distribution de l'ensemble diffèrent par les dimensions de leur corps d'armoire (2), mais sont structurellement identiques en ce qui concerne leur machine frigorifique (20).

10. Utilisation d'un module rapporté (4) présentant une machine frigorifique (20) comportant un premier échangeur de chaleur (21), pour montage sur un corps d'armoire (2) afin de réaliser une armoire de distribution selon l'une des revendications 1 à 8.

11. Utilisation selon la revendication 10, dans laquelle le module rapporté (4) est un élément de rattrapage, c'est-à-dire venant en remplacement d'un couvercle précédemment présent sur le corps d'armoire (2).

12. Utilisation d'une armoire de distribution selon l'une des revendications 1 à 8 à l'extérieur d'un bâtiment, à l'air libre.
